# EUROPEAN PATENT APPLICATION

(11) **EP 4 364 947 A1**
(43) Date of publication of application: **08.05.2024**
(21) Application number: 22833199.7
(22) Date of filing: 29.06.2022
(51) Int. Cl.: B41C 1/00, B41N 1/00, G03F 7/00, G03F 7/028, G03F 7/095, G03F 7/20

(54) **ORIGINAL PLATE FOR FLEXOGRAPHIC PRINTING PLATE AND METHOD FOR PRODUCING FLEXOGRAPHIC PRINTING PLATE**

(30) Priority: 30.06.2021 JP 2021108582
(71) Applicant: FUJIFILM Corporation, Tokyo 106-8620 (JP)
(72) Inventor: WATANABE Kazuki, Haibara-gun, Shizuoka 421-0396 (JP)
(74) Representative: HGF
(86) International application number: PCT/JP2022/025920
(87) International publication number: WO 2023/277053

(57) **Abstract**

An object of the present invention is to provide a flexographic printing plate precursor in which reproducibility of microcells is improved in a case of being made into a flexographic printing plate, and durability of independent dots is improved, and a manufacturing method of a flexographic printing plate using the flexographic printing plate precursor. The flexographic printing plate precursor of the present invention includes, in the following order, an infrared ablation layer, a photosensitive resin layer, and a support, in which a content of a photopolymerization initiator contained in a surface layer region of the photosensitive resin layer from a surface on a side in contact with the infrared ablation layer up to 100 µm in a thickness direction is larger than a content of a photopolymerization initiator contained in a remainder region of the photosensitive resin layer, which is closer to the support side than the surface layer region.

## Description

### BACKGROUND OF THE INVENTION

### 1. Field of the Invention

The present invention relates to a flexographic printing plate precursor and a manufacturing method of a flexographic printing plate using the same.

### 2. Description of the Related Art

A precursor of a flexographic printing plate generally includes a photosensitive resin layer (photosensitive layer) formed of a photosensitive resin composition on a support formed of a polyester film or the like. The flexographic printing plate is formed by exposing a surface of the photosensitive resin layer of the precursor to a predetermined image and then removing a resin in a portion not exposed.

In a so-called analog-type flexographic printing plate precursor, a negative film on which the predetermined image is already formed is placed on the photosensitive resin layer, and the predetermined image is exposed on the surface of the photosensitive resin layer through this negative film.

On the other hand, in a laser ablation mask (LAM)-type flexographic printing plate precursor, an infrared ablation layer is provided in advance on the photosensitive resin layer, an infrared laser is used to draw digitized negative image information directly onto the infrared ablation layer to produce a desired negative pattern, and then the predetermined image is exposed on the surface of the photosensitive resin layer through this negative pattern.

As such a LAM-type flexographic printing plate precursor, for example, JP2012-137515A discloses a flexographic printing plate precursor in which a support, a photosensitive resin layer, and an infrared ablation layer containing a binder polymer and an infrared absorbing substance are laminated.

### SUMMARY OF THE INVENTION

Regarding the known flexographic printing plate precursor disclosed in JP2012-137515A and the like, from the viewpoint of improving ink transferability in a case of being made into a flexographic printing plate, the present inventor has attempted to form a fine uneven pattern (hereinafter, also abbreviated as "microcell") on a surface of an image area of the flexographic printing plate.

The present inventor has found that, in a case where the microcell is formed on the surface of the image area of the flexographic printing plate, chipping or breakage occurs in independent image areas (hereinafter, also abbreviated as "independent dots") having a diameter of approximately 100 to 1,000 µm.

Therefore, an object of the present invention is to provide a flexographic printing plate precursor in which reproducibility of microcells is improved in a case of being made into a flexographic printing plate, and durability of independent dots is improved, and a manufacturing method of a flexographic printing plate using the flexographic printing plate precursor.

As a result of intensive studies to achieve the above-described object, the present inventor has found that, in a flexographic printing plate precursor including an infrared ablation layer, a photosensitive resin layer, and a support in this order, a content of a photopolymerization initiator contained in a surface layer region of the photosensitive resin layer is larger than a content of a photopolymerization initiator contained in a remainder region, the reproducibility of microcells is improved in a case of being made into a flexographic printing plate, and the durability of independent dots is improved, and has completed the present invention.

That is, the present inventor has found that the above-described object can be achieved by adopting the following configurations.
[1] A flexographic printing plate precursor comprising, in the following order:
   an infrared ablation layer;
   a photosensitive resin layer; and
   a support,
   in which a content of a photopolymerization initiator contained in a surface layer region of the photosensitive resin layer from a surface on a side in contact with the infrared ablation layer up to 100 µm in a thickness direction is larger than a content of a photopolymerization initiator contained in a remainder region of the photosensitive resin layer, which is closer to the support side than the surface layer region,
   provided that the content of the photopolymerization initiator contained in the surface layer region and the content of the photopolymerization initiator contained in the remainder region refer to a molar amount with respect to a total mass of solid contents of the photosensitive resin layer in each region.
[2] The flexographic printing plate precursor according to [1],
   in which the content of the photopolymerization initiator contained in the surface layer region is 220 to 400 µmol/g, and
   the content of the photopolymerization initiator contained in the remainder region is 60 to 200 µmol/g.
[3] A manufacturing method of a flexographic printing plate having a non-image area and an image area, the manufacturing method comprising:
   a mask forming step of, with respect to the flexographic printing plate precursor according to [1] or [2], forming an image on the infrared ablation layer included in the flexographic printing plate precursor to form a mask;
   an exposure step of, after the mask forming step, imagewise exposing the photosensitive resin layer included in the flexographic printing plate precursor through the mask; and
   a development step of, after the exposure step, performing development using a developer to form a non-image area and an image area.
[4] The manufacturing method of a flexographic printing plate according to [3],
   in which the developer is an aqueous developer.

According to the present invention, it is possible to provide a flexographic printing plate precursor in which reproducibility of microcells is improved in a case of being made into a flexographic printing plate, and durability of independent dots is improved, and a manufacturing method of a flexographic printing plate using the flexographic printing plate precursor.

### BRIEF DESCRIPTION OF THE DRAWINGS

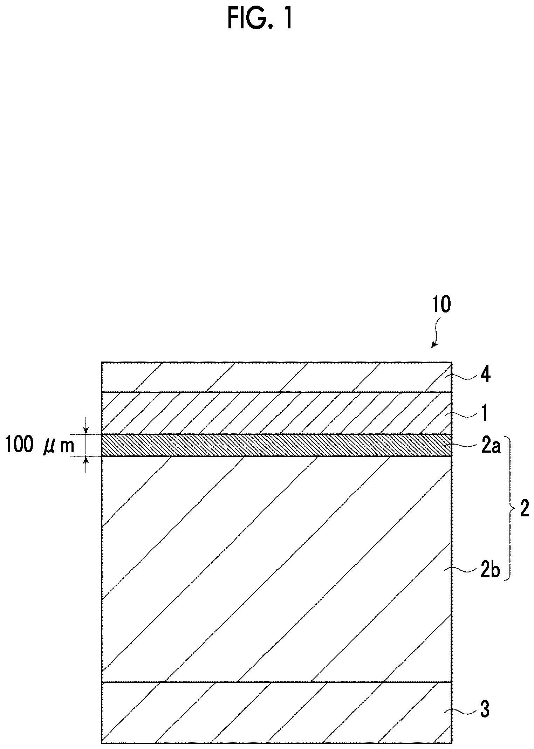

Fig. 1 is a schematic cross-sectional view showing an example of a flexographic printing plate precursor according to the embodiment of the present invention.

### DESCRIPTION OF THE PREFERRED EMBODIMENTS

Hereinafter, the present invention will be described in detail.

The description of configuration requirements described below may be made on the basis of representative embodiments of the present invention, but it should not be construed that the present invention is limited to those embodiments.

In the specification of the present application, the numerical range expressed by using "to" means a range including the numerical values before and after "to" as the lower limit value and the upper limit value.

In addition, in this specification, for each component, one kind of substance corresponding to each component may be used alone, or two or more kinds thereof may be used in combination. Here, in a case where two or more kinds of substances are used in combination for each component, the content of the component indicates the total content of the substances used in combination, unless otherwise specified.

### [Flexographic printing plate precursor]

The flexographic printing plate precursor according to the embodiment of the present invention is a flexographic printing plate precursor including, in the following order, an infrared ablation layer, a photosensitive resin layer, and a support.

In addition, in the flexographic printing plate precursor according to the embodiment of the present invention, a content of a photopolymerization initiator contained in a surface layer region of the photosensitive resin layer from a surface on a side in contact with the infrared ablation layer up to 100 µm in a thickness direction is larger than a content of a photopolymerization initiator contained in a remainder region of the photosensitive resin layer, which is closer to the support side than the surface layer region.

Here, the content of the photopolymerization initiator contained in the surface layer region and the content of the photopolymerization initiator contained in the remainder region refer to a molar amount with respect to a total mass of solid contents of the photosensitive resin layer in each region.

Fig. 1 is a schematic cross-sectional view showing an example of the flexographic printing plate precursor according to the embodiment of the present invention.

A flexographic printing plate precursor 10 shown in Fig. 1 includes an infrared ablation layer 1, a photosensitive resin layer 2 (reference numeral 2a: surface layer region, reference numeral 2b: remainder region), and a support 3 in this order.

In addition, as shown in Fig. 1, the flexographic printing plate precursor according to the embodiment of the present invention may include a cover sheet 4.

In the present invention, as described above, in a case where a content of a photopolymerization initiator contained in the surface layer region of the photosensitive resin layer is larger than a content of a photopolymerization initiator contained in the remainder region, reproducibility of microcells is improved in a case of being made into a flexographic printing plate, and durability of independent dots is improved.

Although the details thereof are not clear, the present inventor has presumed as follows.

First, in the related art, in a case of forming microcells on a surface of an image area of a flexographic printing plate, from the viewpoint of suppressing polymerization inhibition by oxygen, it is necessary to sufficiently proceed curing reaction during exposure by increasing the content of the photopolymerization initiator contained in the photosensitive resin layer.

Therefore, in the related art, the reason why durability of the independent dots is deteriorated is considered to be that ultraviolet rays irradiated during the exposure no longer reach the inside of the photosensitive resin layer, causing curing failure.

Therefore, in the present invention, in a case where the content of the photopolymerization initiator contained in the surface layer region of the photosensitive resin layer, which is affected by the polymerization inhibition by oxygen, is larger than the content of the photopolymerization initiator contained in the remainder region, which is less affected by the polymerization inhibition by oxygen, it is considered that, since the ultraviolet rays irradiated during the exposure are suppressed from being strongly absorbed in the surface layer region of the photosensitive resin layer, the curing reaction in the remainder region of the photosensitive resin layer can also proceed sufficiently, so that it is possible to achieve both the reproducibility of microcells and the durability of independent dots.

Hereinafter, each layer configuration included in the flexographic printing plate precursor according to the embodiment of the present invention will be described in detail.

### [Infrared ablation layer]

The infrared ablation layer included in the flexographic printing plate precursor according to the embodiment of the present invention is a portion serving as a mask which covers the surface of the photosensitive resin layer.

In addition, the infrared ablation layer is a portion which can be removed by an infrared laser, and the unremoved portion shields (absorbs) ultraviolet light to mask the photosensitive resin layer below the unremoved portion from not being irradiated with the ultraviolet light.

Such an infrared ablation layer can be formed using a resin composition containing a binder polymer and an infrared absorbing substance.

### <Binder polymer>

Examples of the binder polymer contained in the resin composition include a polymer component corresponding to a rubber component and a resin component.

### (Rubber component)

The rubber component is not particularly limited as long as it is a rubber which does not hinder adhesiveness with the photosensitive resin layer.

Specific examples of the rubber include butadiene rubber (BR), acrylonitrile butadiene rubber (NBR), acrylic rubber, epichlorohydrin rubber, urethane rubber, isoprene rubber (IR), styrene isoprene rubber (SIR), styrene butadiene rubber (SBR), ethylene-propylene copolymer, and chlorinated polyethylene. These may be used alone or in combination of two or more.

### (Resin component)

The resin component is not particularly limited as long as it is a resin which does not hinder adhesiveness with the photosensitive resin layer.

Specific examples of the resin a (meth)acrylic resin, a polystyrene resin, a polyester resin, a polyamide resin, a polysulfone resin, a polyether sulfone resin, a polyimide resin, an acrylic resin, an acetal resin, an epoxy resin, and a polycarbonate resin, where one kind thereof may be used alone or two or more kinds thereof may be used in combination.

The "(meth)acrylic" is a notation meaning acrylic or methacrylic, and a "(meth)acryloyl" described later is a notation meaning acryloyl or methacryloyl.

Among these, as the polymer component corresponding to the rubber component, butadiene rubber (BR), acrylonitrile butadiene rubber (NBR), or styrene butadiene rubber (SBR) is preferable, and acrylonitrile butadiene rubber (NBR) is more preferable.

In addition, as the polymer component corresponding to the resin component, an acrylic resin or a methacrylic resin is preferable.

### <Infrared absorbing substance>

The infrared absorbing substance contained in the resin composition is not particularly limited as long as it is a substance which can absorb infrared rays and convert the infrared rays into heat.

Specific examples of the infrared absorbing substance include black pigments (for example, carbon black, aniline black, cyanine black, and the like), green pigments (for example, phthalocyanine, naphthalocyanine, and the like), rhodamine coloring agents, naphthoquinone-based coloring agents, polymethine dyes, diimmonium salts, azoimonium-based coloring agents, chalcogen-based coloring agents, carbon graphite, iron powder, diamine-based metal complexes, dithiol-based metal complexes, phenolthiol-based metal complexes, mercaptophenol-based metal complexes, aryl aluminum metal salts, crystal water-containing inorganic compounds, copper sulfate, metal oxides (for example, cobalt oxide, tungsten oxide, and the like), and metal powders (for example, bismuth, tin, tellurium, aluminum, and the like).

Among these, from the viewpoint of having an ultraviolet absorbing function and the like, carbon black, carbon graphite, or the like is preferable.

The infrared ablation layer may contain various additives in addition to the binder polymer and the infrared absorbing substance described above.

Examples of such as additive include a surfactant, a plasticizer, an ultraviolet absorbing substance, a mold release agent, a dye, a pigment, an antifoaming agent, and a fragrance.

A method for producing the infrared ablation layer is not particularly limited, and examples thereof include a method of preparing a resin composition containing each of the above-described components and applying the resin composition to the photosensitive resin layer.

A film thickness of the infrared ablation layer is preferably 0.1 to 6 µm and more preferably 0.5 to 3 µm.

### [Photosensitive resin layer]

The photosensitive resin layer included in the flexographic printing plate precursor according to the embodiment of the present invention can be formed using a known photosensitive resin composition in the related art, except that the content of the photopolymerization initiator is adjusted.

In the present invention, from the reason that the reproducibility of microcells is further improved in a case of being made into a flexographic printing plate, and the durability of independent dots is further improved, the content of the photopolymerization initiator contained in the surface layer region is preferably 220 to 400 µmol/g, and the content of the photopolymerization initiator contained in the remainder region is preferably 60 to 200 µmol/g.

Here, the content of the photopolymerization initiator contained in the surface layer region and the content of the photopolymerization initiator contained in the remainder region can be measured by a method shown below.

First, with the flexographic printing plate precursor, a cross section of the photosensitive resin layer is cut using a microtome, and is separated into two parts of a surface layer region from a surface on a side in contact with the infrared ablation layer up to 100 µm in a thickness direction and a remainder region closer to the support side than the surface layer region.

The sample of each separated region is dissolved completely with tetrahydrofuran (THF) and then diluted to a concentration of 1 mg/1 mL, and using liquid chromatography, the content of the photoinitiator in each region, that is, the molar amount [µmol/g] based on the total mass of the solid content of the photosensitive resin layer in each region is calculated.

In the present invention, it is preferable that the photosensitive resin layer contains water-dispersible particles, a binder, a monomer, and a polymerization inhibitor, in addition to the photopolymerization initiator.

### <Water-dispersible particles>

The water-dispersible particles are not particularly limited, but from the reason that the reproducibility of microcells is further improved in a case of being made into a flexographic printing plate, and the durability of independent dots is further improved, a polymer is preferable. Hereinafter, the "the reproducibility of microcells is further improved in a case of being made into a flexographic printing plate and the durability of independent dots is further improved" is also referred to as "effects of the present invention are more excellent".

Specific examples of the above-described polymer include diene-based polymers (for example, polybutadiene, natural rubber, styrene-butadiene copolymer, acrylonitrile-butadiene copolymer, methyl methacrylate-butadiene copolymer, polychloroprene, and polyisoprene), polyurethane, vinylpyridine polymer, butyl polymer, thiokol polymer, acrylate polymer, and a polymer obtained by copolymerizing these polymers with other components such as acrylic acid and methacrylic acid. These may be used alone or in combination of two or more.

From the reason that water-based ink resistance is more excellent, the above-described polymer is preferably a polymer obtained by polymerizing at least one monomer selected from the group consisting of isoprene, butadiene, styrene, butyl, ethylene, propylene, acrylic acid ester, and methacrylic acid ester, and more preferably polybutadiene.

It is preferable that the above-described polymer does not have a reactive functional group (for example, a (meth)acryloyloxy group) at both terminals.

From the reason that the effects of the present invention are more excellent, it is preferable that the above-described polymer is a polymer obtained by removing water from water-dispersible latex. Specific examples of the above-described water-dispersible latex include water-dispersible latex of specific examples of the above-described polymer.

From the reason that the effects of the present invention are more excellent, a content of the water-dispersible particles is preferably 5% to 80% by mass, more preferably 10% to 60% by mass, and still more preferably 20% to 45% by mass with respect to the total mass of solid content in the photosensitive resin layer.

### <Binder>

The binder is not particularly limited, and examples thereof include a thermoplastic polymer.

The thermoplastic polymer is not particularly limited as long as the thermoplastic polymer is a polymer exhibiting thermoplasticity, and specific examples thereof include a polystyrene resin, a polyester resin, a polyamide resin, a polysulfone resin, a polyethersulfone resin, a polyimide resin, an acrylic resin, an acetal resin, an epoxy resin, a polycarbonate resin, rubbers, and a thermoplastic elastomer. These may be used alone or in combination of two or more.

Among these, from the reason that an elastic and flexible film can be easily formed, a rubber or a thermoplastic elastomer is preferable, a rubber is more preferable, and a diene-based rubber is still more preferable.

As the above-described rubber, in order to secure elasticity of the flexographic plate, a non-fluid rubber which does not have fluidity is preferable.

Specific examples thereof include butadiene rubber (BR), nitrile rubber (NBR), acrylic rubber, epichlorohydrin rubber, urethane rubber, isoprene rubber, styrene isoprene rubber, styrene butadiene rubber (SBR), ethylene-propylene copolymer, and chlorinated polyethylene. These may be used alone or in combination of two or more. Among these, from the reason that water developability is improved, or from the viewpoint of drying properties and image reproducibility, at least one rubber selected from the group consisting of butadiene rubber (BR), styrene butadiene rubber (SBR), and nitrile rubber (NBR) is preferable, and from the viewpoint of water-based ink resistance, butadiene rubber or styrene butadiene rubber is more preferable.

Examples of the above-described thermoplastic elastomer include a polybutadiene-based thermoplastic elastomer (PB), a polyisoprene-based thermoplastic elastomer, a polyolefin-based thermoplastic elastomer, and an acrylic thermoplastic elastomer. Specific examples thereof include polystyrene-polybutadiene (SB), polystyrene-polybutadiene-polystyrene (SBS), polystyrene-polyisoprene-polystyrene (SIS), polystyrene-polyethylene/polybutylene-polystyrene (SEBS), acrylonitrile butadiene styrene copolymer (ABS), acrylic acid ester rubber (ACM), acrylonitrile-chlorinated polyethylene-styrene copolymer (ACS), acrylonitrile-styrene copolymer, syndiotactic 1,2-polybutadiene, and methyl polymethacrylate-butyl polyacrylate-methyl polymethacrylate. Among these, from the reason that water developability is improved, or from the viewpoint of drying properties and image reproducibility, PB, SBS, or SIS is particularly preferable.

A content of the binder is preferably 1% to 50% by mass, more preferably 5% to 40% by mass, and still more preferably 7% to 30% by mass with respect to the total mass of solid content in the photosensitive resin layer.

### <Monomer>

The monomer is not particularly limited, but from the reason that the effects of the present invention are more excellent, it is preferable to use a monofunctional monomer and a bifunctional monomer in combination.

### (Monofunctional monomer)

From the reason that the effects of the present invention are more excellent, the above-described monofunctional monomer is preferably a compound having one ethylenically unsaturated group.

Examples of the ethylenically unsaturated group include a radically polymerizable group such as an acryloyl group, a methacryloyl group, a vinyl group, a styryl group, and an allyl group, and among these, an acryloyl group, a methacryloyl group, or C(O)OCH=CH₂ is preferable, and an acryloyl group or a methacryloyl group is more preferable.

### Examples of the compound having one ethylenically unsaturated group include

N-vinyl compounds such as N-vinylformamide;
(meth)acrylamide compounds such as (meth)acrylamide, N-methylol (meth)acrylamide, diacetone (meth)acrylamide, N,N-dimethyl (meth)acrylamide, N,N-diethyl (meth)acrylamide, N-isopropyl (meth)acrylamide, (meth)acryloylmorpholine, and (meth)acrylamide;
(meth)acrylate compounds such as 2-hydroxyethyl (meth)acrylate, butoxyethyl (meth)acrylate, carbitol (meth)acrylate, cyclohexyl (meth)acrylate, tetrahydrofurfuryl (meth)acrylate, benzyl (meth)acrylate, tridecyl (meth)acrylate, 2-phenoxyethyl (meth)acrylate, glycidyl (meth)acrylate, isobornyl (meth)acrylate, dicyclopentenyl (meth)acrylate, dicyclopentenyloxyethyl (meth)acrylate, dicyclopentanyl (meth)acrylate, 2-hydroxy-3-phenoxypropyl (meth)acrylate, 2-(meth)) acryloyloxyethyl phthalate, methoxy-polyethylene glycol (meth)acrylate, 2-(meth)acryloyloxyethyl-2-hydroxyethyl phthalate, 2-(2-ethoxyethoxy)ethyl (meth)acrylate, 2-methoxyethyl (meth)acrylate, 3-methoxybutyl (meth)acrylate, ethoxylated phenyl (meth)acrylate, 2-(meth)acryloyloxyethyl succinic acid, nonylphenol EO-adduct (meth)acrylate, phenoxy-polyethylene glycol (meth)acrylate, 2-(meth)acryloyloxyethylhexahydrophthalic acid, lactone-modified (meth)acrylate, stearyl (meth)acrylate, isoamyl (meth)acrylate, isomyristyl (meth)acrylate, isostearyl (meth)acrylate, and cyclic trimethylolpropane formal (meth)acrylate; and
monovinyl ether compounds such as methyl vinyl ether, ethyl vinyl ether, n-propyl vinyl ether, isopropyl vinyl ether, n-butyl vinyl ether, isobutyl vinyl ether, t-butyl vinyl ether, n-octadecyl vinyl ether, 2-ethylhexyl vinyl ether, n-nonyl vinyl ether, dodecyl vinyl ether, octadecyl vinyl ether, cyclohexyl vinyl ether, cyclohexyl methyl vinyl ether, 4-methylcyclohexyl methyl vinyl ether, benzyl vinyl ether, dicyclopentenyl vinyl ether, 2-dicyclopentenoxyethyl vinyl ether, methoxyethyl vinyl ether, ethoxyethyl vinyl ether, butoxyethyl vinyl ether, methoxyethoxyethyl vinyl ether, ethoxyethoxyethyl vinyl ether, methoxypolyethylene glycol vinyl ether, tetrahydrofurfuryl vinyl ether, 2-hydroxyethyl vinyl ether, 2-hydroxypropyl vinyl ether, 4-hydroxybutyl vinyl ether, 4-hydroxymethyl cyclohexyl methyl vinyl ether, diethylene glycol monovinyl ether, polyethylene glycol vinyl ether, chlorethyl vinyl ether, chlorobutyl vinyl ether, chloroethoxyethyl vinyl ether, phenylethyl vinyl ether, phenoxypolyethylene glycol vinyl ether, cyclohexanedimethanol monovinyl ether, and isopropenyl ether-O-propylene carbonate.

EO represents ethylene oxide.

From the reason that the effects of the present invention are more excellent, a content of the monofunctional monomer is preferably 0.1% to 30% by mass, and more preferably 1% to 10% by mass with respect to the total mass of solid content in the photosensitive resin layer.

### (Bifunctional monomer)

From the reason that the effects of the present invention are more excellent, the above-described bifunctional monomer is preferably a compound having two ethylenically unsaturated groups. Specific examples of the above-described ethylenically unsaturated group are as described above.

Examples of the compound having two ethylenically unsaturated groups include:
glycol di(meth)acrylate compounds such as ethyleneglycol di(meth)acrylate, diethyleneglycol di(meth)acrylate, triethyleneglycol di(meth)acrylate, tetraethyleneglycol di(meth)acrylate, polyethyleneglycol di(meth)acrylate, propyleneglycol di(meth)acrylate, dipropyleneglycol di(meth)acrylate, tripropyleneglycol di(meth)acrylate, tetrapropyleneglycol di(meth)acrylate, polypropyleneglycol di(meth)acrylate, ethoxylated neopentylglycol di(meth)acrylate, and propoxylated neopentylglycol di(meth)acrylate;
divinyl ether compounds such as ethyleneglycol divinyl ether, diethyleneglycol divinyl ether, triethyleneglycol divinyl ether, propyleneglycol divinyl ether, dipropyleneglycol divinyl ether, butanediol divinyl ether, hexanediol divinyl ether, and cyclohexanedimethanol divinyl ether; and
di(meth)acrylate compounds of bisphenol A such as bisphenol A diglycidyl ether (meth)acrylic acid adduct, modified bisphenol A di(meth)acrylate, bisphenol A PO-adducted di(meth)acrylate, and bisphenol A EO-adducted di(meth)acrylate.

PO represents propylene oxide and EO represents ethylene oxide.

From the reason that the effects of the present invention are more excellent, a content of the bifunctional monomer is preferably 0.1% to 30% by mass with respect to the total mass of solid content in the photosensitive resin layer.

### <Photopolymerization initiator>

The photopolymerization initiator contained in the photosensitive resin layer is not particularly limited, and examples thereof include photopolymerization initiators such as alkylphenones, acetophenones, benzoin ethers, benzophenones, thioxanthones, anthraquinones, benzyls, and biacetyls.

More specific examples thereof include benzyl dimethyl ketal, 2-hydroxy-2-methyl-1-phenyl-propan-1-one, methyl-o-benzoylbenzoate, and 1-hydroxycyclohexyl phenyl ketone.

From the viewpoint of sensitivity or the like, a content of the photopolymerization initiator is preferably 0.3% to 15% by mass and more preferably 0.5% to 10% by mass with respect to the total mass of solid content in the photosensitive resin layer.

### <Polymerization inhibitor>

From the reason that the effects of the present invention are more excellent, the photosensitive resin layer preferably contains a polymerization inhibitor (stabilizer).

Examples of the polymerization inhibitor include phenols, hydroquinones, and catechols.

From the reason that the flexographic printing plate precursor after being stored for a long time has more excellent development scum dispersibility, a content of the polymerization inhibitor is preferably 0.01% to 5% by mass and more preferably 0.01% to 0.5% by mass with respect to the total mass of solid contents of the photosensitive resin layer.

### <Telechelic polymer>

From the reason that the effects of the present invention are more excellent, the photosensitive resin layer preferably contains a telechelic polymer.

In the present specification, the "telechelic polymer" means a polymer which has a reactive functional group at both terminals.

### (Main chain)

A polymer constituting a main chain of the telechelic polymer is not particularly limited, and examples thereof include a thermoplastic polymer.

The thermoplastic polymer is not particularly limited as long as the thermoplastic polymer is a polymer exhibiting thermoplasticity, and specific examples thereof include a polystyrene resin, a polyester resin, a polyamide resin, a polysulfone resin, a polyethersulfone resin, a polyimide resin, an acrylic resin, an acetal resin, an epoxy resin, a polycarbonate resin, rubbers, and a thermoplastic elastomer.

Among these, from the reason that more elastic and flexible film can be easily formed, a rubber or a thermoplastic elastomer is preferable, a rubber is more preferable, and a diene-based rubber is still more preferable.

Specific examples of the above-described rubber include butadiene rubber (BR), nitrile rubber (NBR), acrylic rubber, epichlorohydrin rubber, urethane rubber, isoprene rubber, styrene isoprene rubber, styrene butadiene rubber (SBR), ethylene-propylene copolymer, and chlorinated polyethylene. These may be used alone or in combination of two or more. Among these, from the reason that water developability is improved, or from the viewpoint of drying properties and image reproducibility, at least one rubber selected from the group consisting of butadiene rubber (BR), styrene butadiene rubber (SBR), and nitrile rubber (NBR) is preferable, and butadiene rubber or styrene butadiene rubber is more preferable.

Examples of the above-described thermoplastic elastomer include a polybutadiene-based thermoplastic elastomer (PB), a polyisoprene-based thermoplastic elastomer, a polyolefin-based thermoplastic elastomer, and an acrylic thermoplastic elastomer. Specific examples thereof include polystyrene-polybutadiene (SB), polystyrene-polybutadiene-polystyrene (SBS), polystyrene-polyisoprene-polystyrene (SIS), polystyrene-polyethylene/polybutylene-polystyrene (SEBS), acrylonitrile butadiene styrene copolymer (ABS), acrylic acid ester rubber (ACM), acrylonitrile-chlorinated polyethylene-styrene copolymer (ACS), acrylonitrile-styrene copolymer, syndiotactic 1,2-polybutadiene, and methyl polymethacrylate-butyl polyacrylate-methyl polymethacrylate. Among these, from the reason that water developability is improved, or from the viewpoint of drying properties and image reproducibility, PB, SBS, or SIS is particularly preferable.

### (Terminal)

The telechelic polymer has a reactive functional group at both terminals.

The above-described reactive functional group is not particularly limited, but from the reason that the effects of the present invention are more excellent, an ethylenically unsaturated group is preferable.

From the reason that the effects of the present invention are more excellent, the above-described ethylenically unsaturated group is preferably a vinyl group (CH₂=CH-), an allyl group (CH₂=CH-CH₂-), a (meth)acryloyl group, or a (meth)acryloyl group, and more preferably a (meth)acryloyloxy group.

The telechelic polymer may have a reactive functional group at both terminals of the polymer constituting the main chain through a divalent linking group.

The above-described divalent linking group is not particularly limited, and examples thereof include a linear, branched, or cyclic divalent aliphatic hydrocarbon group (for example, an alkylene group such as a methylene group, an ethylene group, and a propylene group), a divalent aromatic hydrocarbon group (for example, a phenylene group), -O-, -S-, -SO₂-, -NRL-, -CO-, -NH-, -COO-, -CONRL-, -O-CO-O-, -SO₃-, -NHCOO-, -SO₂NRL-, -NH-CO-NH-, and a group in which two or more of these groups are combined (for example, an alkyleneoxy group, an alkyleneoxycarbonyl group, an alkylenecarbonyloxy group, and the like). Here, RL represents a hydrogen atom or an alkyl group (preferably having 1 to 10 carbon atoms).

### (Molecular weight)

From the reason that the effects of the present invention are more excellent, a weight-average molecular weight (Mw) of the telechelic polymer is preferably 6,000 or more, more preferably 7,000 or more, still more preferably 8,000 or more, and particularly preferably 9,000 or more. The upper limit of Mw of the telechelic polymer is not particularly limited, but from the reason that the effects of the present invention are more excellent, it is preferably 500,000 or less and more preferably 100,000 or less.

Here, the weight-average molecular weight is measured by a gel permeation chromatograph method (GPC) and is obtained by converting with standard polystyrene. Specifically, for example, HLC-8220 GPC (manufactured by Tosoh Corporation) is used as GPC, three of TSKgeL SuperHZM-H, TSKgeL SuperHZ4000, and TSKgeL SuperHZ2000 (all manufactured by Tosoh Corporation, 4.6 mmID × 15 cm) are used as a column, and tetrahydrofuran (THF) is used as an eluent. In addition, as the conditions, a sample concentration of 0.35% by mass, a flow rate of 0.35 mL/min, a sample injection amount of 10 µL, and a measurement temperature of 40°C are set, and an IR detector is used. In addition, a calibration curve is created using 8 samples of "F-40", "F-20", "F-4", "F-1", "A-5000", "A-2500", "A-1000", and "n-propylbenzene" which are "Standard Samples TSK standard, polystyrene" (manufactured by TOSOH Corporation).

### (HSP value)

A Hansen solubility parameter (HSP) value of the telechelic polymer is not particularly limited, but from the reason that the effects of the present invention are more excellent, it is preferably 8 to 12, more preferably 8.5 to 11, and still more preferably 8.5 to 10.5.

### (Content)

From the reason that the effects of the present invention are more excellent, a content of the telechelic polymer is preferably 1% to 50% by mass, more preferably 5% to 40% by mass, still more preferably 7% to 30% by mass, and particularly preferably 10% to 20% by mass with respect to the total mass of solid content in the photosensitive resin layer.

### <Plasticizer>

From the reason that flexibility is further improved, the photosensitive resin layer preferably contains a plasticizer.

Specific examples of the plasticizer include liquid rubber, oil, polyester, and phosphoric acid-based compounds.

Specific examples of the liquid rubber include liquid polybutadiene, liquid polyisoprene, and compounds in which these compounds are modified with maleic acid or an epoxy group.

Specific examples of the oil include paraffin, naphthene, and aroma.

Specific examples of the polyester include adipic acid-based polyester.

Specific examples of the phosphoric acid-based compound include phosphoric acid ester.

From the reason that the flexibility is further improved, a content of the plasticizer is preferably 0.1% to 40% by mass, and more preferably 5% to 30% by mass with respect to the total mass of solid content in the photosensitive resin layer.

### <Surfactant>

From the viewpoint of further improving the water developability, the photosensitive resin layer preferably contains a surfactant.

Examples of the surfactant include a cationic surfactant, an anionic surfactant, and a nonionic surfactant. Among these, from the reason that the effects of the present invention are more excellent, an anionic surfactant is preferable.

Specific examples of the anionic surfactant include:
aliphatic carboxylates such as sodium laurate, and sodium oleate;
higher alcohol sulfate salts such as sodium lauryl sulfate, sodium cetyl sulfate, and sodium oleyl sulfate;
polyoxyethylene alkyl ether sulfate ester salts such as sodium polyoxyethylene lauryl ether sulfate;
polyoxyethylene alkyl allyl ether sulfate ester salts such as sodium polyoxyethylene octyl phenyl ether sulfate and sodium polyoxyethylene nonyl phenyl ether sulfate;
alkyl sulfonates such as alkyl diphenyl ether disulfonate, sodium dodecyl sulfonate, and sodium dialkyl sulfosuccinate;
alkyl allyl sulfonates such as alkyl disulfonate, sodium dodecyl benzene sulfonate, sodium dibutyl naphthalene sulfonate, and sodium triisopropyl naphthalene sulfonate;
higher alcohol phosphate ester salts such as disodium lauryl phosphate monoester, and sodium lauryl phosphate diester; and
polyoxyethylene alkyl ether phosphate ester salts such as disodium polyoxyethylene lauryl ether phosphate monoester, and sodium polyoxyethylene lauryl ether phosphate diester.

These may be used alone or in combination of two or more.

Among these, from the reason that the water developability is further improved, sulfonic acid-based surfactants such as alkyl sulfonate and alkyl allyl sulfonate are preferable.

From the viewpoint of developability and drying properties after development, a content of the surfactant is preferably 0.1% to 20% by mass, and more preferably 1% to 10% by mass with respect to the total mass of solid content in the photosensitive resin layer.

### <Other additives>

To the extent that the effects of the present invention are not impaired, other additives such as an ultraviolet absorber, a dye, a pigment, an anti-foaming agent, and a fragrance can be appropriately further added to the photosensitive resin layer, for the purpose of improving various properties.

### <Method for producing photosensitive resin layer>

A method for producing the photosensitive resin layer is not particularly limited, and examples thereof include a method of preparing a resin composition containing each of the above-described components and applying the resin composition onto a support described later.

In the present invention, from the viewpoint that it is easy to adjust the content of the photopolymerization initiator contained in the surface layer region of the photosensitive resin layer to be larger than the content of the photopolymerization initiator contained in the remainder region of the photosensitive resin layer, it is preferable that the photosensitive resin layer is composed of a plurality of layers, and examples thereof include a method of applying a resin composition onto a support to form a photosensitive resin layer (second photosensitive resin layer containing less photopolymerization initiator), and then applying another resin composition onto the second photosensitive resin layer to form a photosensitive resin layer (first photosensitive resin layer containing more photopolymerization initiator); and a method of forming the first photosensitive resin layer and the second photosensitive resin layer using a calender roll or the like, and then bonding them together using a press machine or the like.

A film thickness of the photosensitive resin layer is preferably 0.01 to 10 mm and more preferably 0.2 to 6 mm.

In addition, in a case where the photosensitive resin layer is composed of a plurality of layers, a film thickness of the photosensitive resin layer including the surface layer region (first photosensitive resin layer) is preferably 0.1 to 0.4 mm, and a film thickness of the photosensitive resin layer including the surface layer region (second photosensitive resin layer) is preferably 0.5 to 5 mm.

### [Support]

A material used for the support included in the flexographic printing plate precursor according to the embodiment of the present invention is not particularly limited, and a support with high dimensional stability is preferably used. Examples thereof include metals such as steel, stainless steel, and aluminum; polyester (for example, polyethylene terephthalate (PET), polybutylene terephthalate (PBT), polyethylene naphthalate (PEN), polyimide (PI), polyamide, liquid crystal polymer (LCP), and polyacrylonitrile (PAN)); plastic resins such as polyvinyl chloride; synthetic rubber such as styrene-butadiene rubber; glass fiber reinforced plastic resin (such as epoxy resin and phenolic resin); and cloth and paper.

From the viewpoint of dimensional stability and availability, the support is preferably a polymer film or cloth, and more preferably a polymer film. The morphology of the support is determined by whether the polymer layer is sheet-like or sleeve-like.

As the cloth, plain or twill weave fabrics and various knitted fabrics of natural fibers such as cotton, linen, silk, and wool or synthetic fibers such as acetate, vinylon, vinylidene, polyvinyl chloride, acrylic, polypropylene, polyethylene, polyurethane, fluorine filament, polyclar, rayon, nylon, polyamide, and polyester, or nonwoven fabrics can be used.

Examples of the polymer film include a film formed of various polymers such as polyester (for example, polyethylene terephthalate (PET), polybutylene terephthalate (PBT), polyethylene naphthalate (PEN), polyimide (PI), polyamide, liquid crystal polymer (LCP), and polyacrylonitrile (PAN)); plastic resins such as polyvinyl chloride; synthetic rubber such as styrene-butadiene rubber; and glass fiber reinforced plastic resin (such as epoxy resin and phenolic resin). Among these, from the viewpoint of dimensional stability and the like, a polyester film is preferable.

Examples of the above-described polyester film include a PET film, a PBT film, and a PEN film, and from the viewpoint of dimensional stability and the like, a polyethylene terephthalate (PET) film is preferable.

A film thickness of the support is not particularly limited, but from the viewpoint of dimensional stability and handleability, it is preferably 5 to 3,000 µm, more preferably 50 to 2,000 µm, and still more preferably 100 to 1,000 µm.

### [Cover sheet]

As shown in Fig. 1, the flexographic printing plate precursor according to the embodiment of the present invention may include a cover sheet.

Such a cover sheet is not particularly limited, but is preferably a transparent polymer film and may be one layer alone or two or more layers laminated.

Here, the "transparent" in the present invention means that a transmittance of visible light is 60% or more, preferably 80% or more and particularly preferably 90% or more.

Examples of a material of the polymer film include cellulose-based polymers; acrylic polymers having an acrylic acid ester polymer such as polymethyl methacrylate and a lactone ring-containing polymer; thermoplastic norbornene-based polymers; polycarbonate-based polymers; polyester-based polymers such as polyethylene terephthalate, polyethylene naphthalate, and a fluoropolyester polymer; styrene-based polymers such as polystyrene and an acrylonitrile-styrene copolymer (AS resin); polyolefin-based polymers such as polyethylene, polypropylene, an ethylene-propylene copolymer, and polybutadiene; vinyl chloride-based polymers; amide-based polymers such as nylon and aromatic polyamide; imide-based polymers; sulfone-based polymers; polyether sulfone-based polymers; polyether ether ketone-based polymers; polyphenylene sulfide-based polymers; vinylidene chloride-based polymers; vinyl alcohol-based polymers; vinyl butyral-based polymers; arylate-based polymers; polyoxymethylene-based polymers; epoxy-based polymers; and polymers obtained by mixing these polymers.

In addition, a surface (surface on which the infrared ablation layer is formed) of the cover sheet may be subjected to peeling treatment for suppressing adhesion of the infrared ablation layer and enhancing peelability of the cover sheet. Examples of such a peeling treatment include a method of applying a peeling agent to the surface of the cover sheet to form a peeling layer. Examples of the peeling agent include a silicone-based peeling agent and an alkyl-based peeling agent.

A film thickness of the cover sheet is preferably 25 to 250 µm.

### [Manufacturing method of flexographic printing plate]

The manufacturing method of a flexographic printing plate according to the embodiment of the present invention is a manufacturing method of a flexographic printing plate having a non-image area and an image area, the manufacturing method including:
a mask forming step of forming an image on the infrared ablation layer included in the above-described flexographic printing plate precursor according to the embodiment of the present invention to form a mask;
an exposure step of, after the mask forming step, imagewise exposing the photosensitive resin layer included in the above-described flexographic printing plate precursor according to the embodiment of the present invention through the mask; and
a development step of, after the above-described exposure step, performing development using a developer to form a non-image area and an image area.

### [Mask forming step]

The above-described mask forming step is a step of forming an image on the infrared ablation layer to form a mask to be used in the exposure step described later.

Here, in the infrared ablation layer, in a case of being irradiated with an infrared laser, the action of the infrared absorbing substance generates heat, which decomposes the infrared ablation layer to be removed, that is, to laser-ablate the infrared ablation layer.

Therefore, by selectively laser-ablating the infrared ablation layer based on the image data, it is possible to obtain an image mask capable of forming a latent image on the photosensitive resin layer.

For the infrared laser irradiation, an infrared laser having an oscillation wavelength in a range of 750 nm to 3,000 nm is used.

Examples of such a laser include a solid-state laser such as a ruby laser, an Alexandrite laser, a perovskite laser, an Nd-YAG laser, and an emerald glass laser; a semiconductor laser such as InGaAsP, InGaAs, and GaAsAl; and a coloring agent laser such as a Rhodamine coloring agent.

In addition, a fiber laser which amplifies these light sources with a fiber can also be used.

Among these, from the reason that the sensitivity of the infrared ablation layer is increased, it is preferable to use an exposure light source having an oscillation wavelength of 900 to 1,200 nm, and it is more preferable to use a fiber laser.

### [Exposure step]

The above-described exposure step is a step of imagewise exposing the photosensitive resin layer through the mask obtained in the above-described mask forming step, and by imagewise irradiating the photosensitive resin layer with ultraviolet rays, crosslinking and/or polymerization of regions irradiated with the ultraviolet rays can be induced to be cured.

### [Development step]

The above-described development step is a step of performing development using a developer to form a non-image area and an image area.

The developer used in the above-described development step is not particularly limited, and known developer in the related art can be used. However, from the viewpoint of reducing the environmental load, it is preferable to use a developer containing 50% by mass or more of water (hereinafter, also abbreviated as "aqueous developer"). The developer may be an aqueous solution or a suspension (for example, an aqueous dispersion liquid).

In addition, a content of water contained in the aqueous developer is preferably 80% to 99.99% by mass and more preferably 90% to 99.9% by mass with respect to the total mass of the aqueous developer.

### [Rinse step]

It is preferable that the manufacturing method of a flexographic printing plate according to the embodiment of the present invention includes a rinse step of, after the above-described development step, rinsing surfaces of the non-image area and the image area formed in the above-described development step with water.

As a rinsing method in the rinse step, a method of washing with tap water, a method of spraying high pressure water, a method of rubbing the surfaces of the non-image area and the image area with a brush using a known batch-type or transport-type brush-type washing machine as a developing machine for flexographic printing plates mainly in the presence of water, and the like may be used.

### Examples

Hereinafter, the present invention will be described in more detail with reference to examples. Materials, amounts used, ratios, treatment contents, treatment procedures, and the like shown in the following examples can be appropriately changed without departing from the spirit of the present invention. Therefore, the scope of the present invention should not be construed as being limited by the following examples.

### [Example 1]

### [Production of first photosensitive resin layer]

63.6 parts by mass of a water-dispersible latex (manufactured by ZEON CORPORATION, Nipol LX111NF, water-dispersible latex of polybutadiene, solid content: 55%), 11 parts by mass of a telechelic polymer (manufactured by OSAKA ORGANIC CHEMICAL INDUSTRY LTD., BAC-45; polybutadiene having acryloyloxy groups at both terminals, Mw = 10,000), and 9 parts by mass of 1,9-nonanediol dimethacrylate (NK ESTER NOD-N, manufactured by Shin-Nakamura Chemical Co., Ltd.) were mixed with each other, and moisture was evaporated for 3 hours in a dryer heated to 60°C to obtain a mixture containing water-dispersible particles.

The mixture, 23 parts by mass of butadiene rubber (manufactured by Asahi Kasei Co., Ltd., NF35R), 15 parts by mass of a plasticizer (manufactured by Idemitsu Kosan Co., Ltd., Diana Process Oil PW-32), and 4 parts by mass of a surfactant (manufactured by NOF CORPORATION, RAPISOL A-90, effective content: 90%) were kneaded in a kneader set at 110°C for 45 minutes. Thereafter, 0.2 parts by mass of a thermal polymerization inhibitor and 8.1 parts by mass of a photopolymerization initiator (manufactured by Tokyo Chemical Industry Co. Ltd., benzyl dimethyl ketal) were put into the kneader, and the mixture was kneaded for 5 minutes to obtain a first photosensitive resin composition.

Subsequently, the first photosensitive resin composition obtained above was molded into a sheet using a calender roll. A warm-up roll was set to 50°C, the first photosensitive resin composition was pre-kneaded for 10 minutes, and a material wound around the roll was cut in the middle to draw a sheet and temporarily wound into a roll. Thereafter, the kneaded material was set between a first roll and a second roll of the calender roll, and subjected to roll molding. Regarding the temperature of each roll of the calender roll, the temperature of the first roll was set to 30°C, the temperature of the second roll was set to 40°C, the temperature of a third roll was set to 50°C, and the temperature of a fourth roll was set to 60°C. Regarding the roll spacing, a spacing between the first roll and the second roll was set to 1.0 mm, a spacing between the second roll and the third roll was set to 0.4 mm, and a spacing between the third roll and the fourth roll was set to 0.2 mm. A transportation speed was set to 1 m/min. After passing through the fourth roll, a first photosensitive resin layer was obtained.

### [Production of second photosensitive resin layer]

63.6 parts by mass of a water-dispersible latex (manufactured by ZEON CORPORATION, Nipol LX111NF, water-dispersible latex of polybutadiene, solid content: 55%), 11 parts by mass of a telechelic polymer (manufactured by OSAKA ORGANIC CHEMICAL INDUSTRY LTD., BAC-45; polybutadiene having acryloyloxy groups at both terminals, Mw = 10,000), and 9 parts by mass of 1,9-nonanediol dimethacrylate (NK ESTER NOD-N, manufactured by Shin-Nakamura Chemical Co., Ltd.) were mixed with each other, and moisture was evaporated for 3 hours in a dryer heated to 60°C to obtain a mixture containing water-dispersible particles.

The mixture, 23 parts by mass of butadiene rubber (manufactured by Asahi Kasei Co., Ltd., NF35R), 15 parts by mass of a plasticizer (manufactured by Idemitsu Kosan Co., Ltd., Diana Process Oil PW-32), and 4 parts by mass of a surfactant (manufactured by NOF CORPORATION, RAPISOL A-90, effective content: 90%) were kneaded in a kneader set at 110°C for 45 minutes. Thereafter, 0.2 parts by mass of a thermal polymerization inhibitor and 4.5 parts by mass of a photopolymerization initiator (manufactured by Tokyo Chemical Industry Co. Ltd., benzyl dimethyl ketal) were put into the kneader, and the mixture was kneaded for 5 minutes to obtain a second photosensitive resin composition.

Subsequently, the second photosensitive resin composition obtained above was molded into a sheet using a calender roll. A warm-up roll was set to 50°C, the second photosensitive resin composition was pre-kneaded for 10 minutes, and a material wound around the roll was cut in the middle to draw a sheet and temporarily wound into a roll. Thereafter, the kneaded material was set between a first roll and a second roll of the calender roll, and subjected to roll molding. Regarding the temperature of each roll of the calender roll, the temperature of the first roll was set to 30°C, the temperature of the second roll was set to 40°C, the temperature of a third roll was set to 50°C, and the temperature of a fourth roll was set to 60°C. Regarding the roll spacing, a spacing between the first roll and the second roll was set to 2.0 mm, a spacing between the second roll and the third roll was set to 1.5 mm, and a spacing between the third roll and the fourth roll was set to 1.1 mm. A transportation speed was set to 1 m/min. After passing through the fourth roll, a second photosensitive resin layer was obtained.

### [Production of laminate for infrared ablation layer]

600 parts by mass of methyl isobutyl ketone was added to 50 parts by mass of an acrylic resin ("Hi-pearl M5000" manufactured by Negami Chemical Industrial Co., Ltd.), 50 parts by mass of an elastomer (NBR, "Nipol DN101" manufactured by Zeon Corporation), and 100 parts by mass of carbon black ("MA8" manufactured by Mitsubishi Chemical Corporation) as an infrared absorbing pigment and mixed with a blade impeller, the obtained mixed solution was dispersed with a paint shaker, and then methyl isobutyl ketone was further added thereto so that the solid content was 15% by mass, thereby obtaining a polymer/carbon black dispersion liquid (coating liquid for infrared ablation layer).

Next, the coating liquid for an infrared ablation layer was applied onto one surface of a silica-containing PET film having a thickness of 75 µm (TOYOBO Ester film U4, manufactured by TOYOBO CO., LTD.), which was a cover sheet, using a bar coater such that a thickness after drying was 1.0 µm, and then dried for 1 minute in an oven set at 140°C to produce a laminate for an infrared ablation layer, which included the cover sheet and the infrared ablation layer.

### [Production of flexographic printing plate precursor]

An adhesive was applied to one surface of a PET film (support) having a thickness of 125 µm to form an adhesive layer on the substrate.

Next, the first photosensitive resin layer and the second photosensitive resin layer were laminated between the above-described adhesive layer and the infrared ablation layer of the laminate for an infrared ablation layer produced as described above so that the first photosensitive resin layer was placed on the infrared ablation layer side, and the laminate was pressed using a press machine heated to 80°C so that the total thickness of the photosensitive resin layers was 1.14 mm, thereby producing a flexographic printing plate precursor including the support, the adhesive layer, the photosensitive resin layers, the infrared ablation layer, and the cover sheet in this order. The thickness of the first photosensitive resin layer and the thickness of the second photosensitive resin layer, shown in Table 1, were the thicknesses before the pressing.

Regarding the obtained flexographic printing plate precursor, the content of the photopolymerization initiator in the surface layer region of the photosensitive resin layer and the content of the photopolymerization initiator in the remainder region were measured by the above-described method. The results are shown in Table 1 below.

### [Production of flexographic printing plate]

With the obtained flexographic printing plate precursor, a printing plate was produced using the following device.

Specifically, the obtained flexographic printing plate precursor was back-exposed by exposing a back surface of the flexographic printing plate precursor with energy of 80 W for 18 seconds using the following ultraviolet exposure machine.

Next, using the following imaging machine, imaging was performed by ablating the infrared ablation layer, and main exposure was performed by exposing a front surface (back surface of the back surface) at 80 W for 180 seconds.

Next, development was performed for 12 minutes using the following washing machine and washing solution.

Next, the obtained product was dried with hot air of 60°C until the moisture was removed.

Next, using the following ultraviolet exposure device, exposure (post-exposure) was performed from the photosensitive resin layer side for 720 seconds to produce a flexographic printing plate.

### <Imaging machine>

· CDI Spark 4835 Inline (manufactured by ESKO)

### <Exposure machine>

· Ultraviolet exposure machine Concept 302 ECDLF (product name) (manufactured by Glunz & Jensen)

### <Washing machine>

· C-Touch 2530 Water Wash Plate Processor (manufactured by GS TRADING)

### <Washing solution>

· Aqueous solution of FINISH POWER & PURE POWDER SP (manufactured by Reckitt Benckiser Japan Ltd.) (concentration: 0.5% by mass)

### [Examples 2 and 3 and Comparative Examples 1 to 3]

A flexographic printing plate precursor was produced according to the same procedure as in Example 1, except that the content of the photopolymerization initiator and the thickness of the photosensitive resin layer were changed to values shown in Table 1 below. Comparative Examples 1 and 2 are examples in which the first photosensitive resin layer was not provided and only the second photosensitive resin layer was provided as the photosensitive resin layer.

Next, a flexographic printing plate was produced using the produced flexographic printing plate precursor according to the same procedure as in Example 1, except that the exposure time was changed to a time shown in Table 1 below.

### [Evaluation]

### [Microcell reproducibility]

The obtained flexographic printing plate was evaluated for microcell reproducibility (MC) by the following method.

First, using a hybrid laser microscope OPTELICS (registered trademark) HYBRIDE (manufactured by Lasertec Corporation), a confocal measurement was performed on a surface of the solid image area of the flexographic printing plate in increments of 0.1 µm in height with a 50x Apo objective lens (high numerical aperture (high NA)) to obtain three-dimensional data. An evaluation range was defined as a region of 300 µm in length and 300 µm in width.

From the observation image based on the above-described three-dimensional data, 100 or more convex portions were observed, and the number of reproduced portions without chipping was determined.

Next, an image reproduction% was calculated by the following expression.

Image reproduction% = (Number of reproduced convex portions without chipping)/(Number of evaluations) × 100

The evaluation was performed using the following standards. The results are shown in Table 1 below.

In order to obtain a printed article having a higher solid density, the image reproduction of the microcells is preferably C to A, more preferably B or A, and still more preferably A. In a case where the image reproduction was less than 80%, unevenness of the ink transferred to the printed article was large, and the solid density was deteriorated.

### <Evaluation standard>

A: image reproduction was 98% or more.
B: image reproduction was 90% or more and less than 98%.
C: image reproduction was 80% or more and less than 90%.
D: image reproduction was less than 80%.

### [Durability of independent dots]

The image area of the obtained flexographic printing plate was rubbed 4 times using a continuous load-type scratch resistance strength tester (HEIDON TYPE: 18) and using a cotton waste cloth as a rubbing member under conditions of a load of 500 g and a reciprocating speed of 100 mm/min. For 10 independent dots with a diameter of 500 µm, which had been specified before the rubbing test, whether or not the independent dots were chipped or broken after the rubbing test was evaluated according to the following standard.

Practically, from the viewpoint of handleability, C to A are preferable, B or A is more preferable, and A is still more preferable.

### <Evaluation standard>

A: none of the 10 independent dots were chipped or broken.
B: 1 of the 10 independent dots was chipped or broken.
C: 2 of the 10 independent dots were chipped or broken.
D: 3 or more of the 10 independent dots were chipped or broken.

**[Table 1]**

| | Flexographic printing plate precursor | | | | | | | | | Exposure time (second) | | | Evaluation result | |
|---|---|---|---|---|---|---|---|---|---|---|---|---|---|---|
| | Cover sheet | Infrared ablation layer | Photosensitive resin layer | | | | | | Support | | | | MC reproducibility | Durability of independent dots |
| | | | First photosensitive resin layer | | Second photosensitive resin layer | | Average value of contents of photopolymerization initiator | | | Back exposure | Main exposure | Post-exposure | | |
| | | | Content of photopolymerization initiator (part by mass) | Thickness (mm) | Content of photopolymerization initiator (part by mass) | Thickness (mm) | Surface layer region | Remainder region | | | | | | |
| Example 1 | Y | Y | 8.1 | 0.2 | 4.5 | 1.1 | 300 | 172 | Y | 18 | 180 | 720 | A | B |
| Example 2 | Y | Y | 8.4 | 0.2 | 6.2 | 1.1 | 312 | 234 | Y | 25 | 540 | 720 | A | C |
| Example 3 | Y | Y | 5.1 | 0.2 | 3.0 | 1.1 | 195 | 117 | Y | 10 | 120 | 720 | C | A |
| Comparative Example 1 | Y | Y | None | None | 8.1 | 1.2 | 300 | 300 | Y | 50 | 720 | 720 | A | D |
| Comparative Example 2 | Y | Y | None | None | 4.5 | 1.2 | 172 | 172 | Y | 18 | 180 | 720 | D | A |
| Comparative Example 3 | Y | Y | 4.5 | 0.2 | 8.1 | 1.1 | 172 | 300 | Y | 50 | 720 | 720 | D | D |

From the results shown in Table 1, in a case where the content of the photopolymerization initiator contained in the surface layer region of the photosensitive resin layer was the same value as the content of the photopolymerization initiator contained in the remainder region, it was found that, in a case where the content was high, the durability of independent dots was deteriorated (Comparative Example 1), and in a case where the content was low, the reproducibility of microcells was deteriorated in a case of being made into a flexographic printing plate (Comparative Example 2).

In addition, in a case where the content of the photopolymerization initiator contained in the surface layer region of the photosensitive resin layer was lower than the content of the photopolymerization initiator contained in the remainder region, the reproducibility of microcells in a case of being made into a flexographic printing plate and the durability of independent dots were all deteriorated (Comparative Example 3).

On the other hand, it was found that, in a case where the content of the photopolymerization initiator contained in the photosensitive resin layer was larger than the content of the photopolymerization initiator contained in the remainder region, the reproducibility of microcells was improved in a case of being made into a flexographic printing plate and the durability of independent dots was improved (Examples 1 to 3).

In addition, from the comparison between Examples 1 to 3, it was found that, in a case where the content of the photopolymerization initiator contained in the surface layer region was 220 to 400 µmol/g and the content of the photopolymerization initiator contained in the remainder region was 60 to 200 µmol/g, the reproducibility of microcells was further improved in a case of being made into a flexographic printing plate and the durability of independent dots was further improved.

### Explanation of References

1: infrared ablation layer
2: photosensitive resin layer
2a: surface layer region
2b: remainder region
3: support
4: cover sheet
10: flexographic printing plate precursor

## Claims

1. A flexographic printing plate precursor comprising, in the following order:
an infrared ablation layer;
a photosensitive resin layer; and
a support,
wherein a content of a photopolymerization initiator contained in a surface layer region of the photosensitive resin layer from a surface on a side in contact with the infrared ablation layer up to 100 µm in a thickness direction is larger than a content of a photopolymerization initiator contained in a remainder region of the photosensitive resin layer, which is closer to the support side than the surface layer region,
provided that the content of the photopolymerization initiator contained in the surface layer region and the content of the photopolymerization initiator contained in the remainder region refer to a molar amount with respect to a total mass of solid contents of the photosensitive resin layer in each region.

2. The flexographic printing plate precursor according to claim 1,
wherein the content of the photopolymerization initiator contained in the surface layer region is 220 to 400 µmol/g, and
the content of the photopolymerization initiator contained in the remainder region is 60 to 200 µmol/g.

3. A manufacturing method of a flexographic printing plate having a non-image area and an image area, the manufacturing method comprising:
a mask forming step of, with respect to the flexographic printing plate precursor according to claim 1 or 2, forming an image on the infrared ablation layer included in the flexographic printing plate precursor to form a mask;
an exposure step of, after the mask forming step, imagewise exposing the photosensitive resin layer included in the flexographic printing plate precursor through the mask; and
a development step of, after the exposure step, performing development using a developer to form a non-image area and an image area.

4. The manufacturing method of a flexographic printing plate according to claim 3, wherein the developer is an aqueous developer.
